# EUROPEAN PATENT APPLICATION

(11) **EP 2 778 314 A1**
(43) Date of publication of application: **17.09.2014**
(21) Application number: 12847585.2
(22) Date of filing: 07.11.2012
(51) Int. Cl.: E04D 13/18, H01L 31/042

(54) **SOLAR CELL MODULE AND SOLAR CELL ARRAY ROOFING STRUCTURE USING SAME**

(30) Priority: 08.11.2011 JP 2011244268
(71) Applicant: XSOL Co. Ltd., Kyoto-shi, Kyoto 604-8152 (JP)
(72) Inventor: KAWAKATSU, Kazushi, Kyoto-shi, Kyoto 604-8152 (JP)
(74) Representative: Loyer & Abello
(86) International application number: PCT/JP2012/078817
(87) International publication number: WO 2013/069673

(57) **Abstract**

Disclosed is a solar cell array configured such that a solar cell module is directly fixed to a roof. On a top end of the solar cell module (1), right and left positioned racks (3) including a terminal box (34) are placed at right and left ends, a centrically positioned rack (2) at a middle position, and each of racks (2, 3) are directly fixed to the roof so as to roof the solar cell module (1). The terminal box (34) includes a connector (35) connected to an output terminal of the solar cell module (1), and a terminal (351), the terminal boxes (34) of the right and left positioned racks (3) are mutually overlaid, the solar cell module (1) is in series connected by a connection cable (36), so as to output power to a power conditioner every step. The solar cell modules (1) are sequentially fixed from the below to the above by a fixture (7) arranged in a starter (5) near roof eaves of a roof (8) and racks (2, 3), forming the solar cell array A.

## Description

### [Technical Field]

This invention relates to solar cell modules and roofing structures for solar cell arrays using the solar cell modules.

### [Background Art]

A roof integrated solar cell module is, for example, configured to fill between a front cover and a back cover solar cell, an inter connector and a filler, and to place back the back cover, a terminal box, wherein the front cover is, for example, made of such toughened glass, transparent synthetic resin, or laminated film, the back cover is made of steal plate, or laminated film, and a cable from the terminal box is further connected to an external cable and is wired to a power conditioner. At this time, generally, in roofing the solar cell module onto a roof onto a roofboard fixed to roof structure material to cover the roof, a frame bar is placed, the solar cell module is then placed, and is fixed to the roof by using a rectangular metal plate (a choshi) with such screw or nail, and building work is performed on the spot.

### [Citation List]

### [Non Patent Literature]

NPTL 1: "Design and Work for Solar Power System (3rd revision)" (issued on December 5, 2010, Ohm Co.)

### [Summary of Invention]

### [Technical Problem]

Roofing of a solar cell module onto a roof face, in this case, requires wiring work for output circuit of the solar cell module by connection of a cable from a terminal box to an external cable, and fixing work fixing the solar cell module onto a roof face, but disadvantageously, building work is liable to be complicated for roofing of the solar cell module on the roof which is located high because wiring work is required to complete prior to fixing work due to the terminal box being located in a back middle of the solar cell module.

This invention is made in view of the foregoing problems, and what is to be solved is to provide a solar cell module ultimately facilitating work on the spot and securely roofing as well by reducing work on the spot, and to provide a roofing structure of a solar cell array using the solar cell module.

### [Solution to Problem]

The present invention for resolving the foregoing problems is related to a solar cell module including: a plurality of racks located in a top end length direction of the solar cell module wherein the racks are placed and fixed onto a roof, and the solar cell module is thereby roofed onto the roof via the racks; a terminal box (which may be called a terminal arrangement space) integrally or in an integrated fashion located to some of of all of the racks in the top end length direction; a connector located in the terminal box; and a connecting cable configured to be arranged in the length direction, and wherein the connecting cable is connected to the connector so as to be arranged in the length direction. This is made such that placing of the solar cell module of the invention recited above in the top end length direction, and placing and fixing of the rack onto the roof allow the module to be roofed on the roof face via the rack, placing the terminal box integrally or in the integrated fashion to the portion or entirety of the rack on the top and in the length direction, and connecting the connector arranged in the terminal box allow the connecting cable to be arranged in the top end length direction.

Preferably, in addition to the above, fixing the rack onto the roof is made so as to directly fix the rack onto a roof face of the roof with a fixture such as screw or nail, and thus the solar cell module is roofed with general tool such as electric screwdriver or hammer. This is made in such a fashion that the rack is placed and fixed onto the roof by directly fixing the rack onto the roof face of the roof with the fixture such as screw or nail.

Preferably, in addition to the above, a lower side of an upper solar cell module located up and down is fixed to the rack fixed to the lower solar cell module with fixture, and thereby the upper solar module is securely roofed without blowing out subsequently toward vertical direction, and the upper and lower solar cell modules are consequently well fixed and secured to the roof face. This can is made in such a fashion as to have a fixture receiver of a fixture fastening a lower side of the solar cell module located above arranged the portion or the entirety of the rack.

Preferably, in addition to the above, the rack is, in order to restrict a weight increase of the solar cell module induced by arrangement thereof, designed to have such material as light as possible, and as high processing accuracy as possible as a rack to roof the solar cell module. This is made such that the rack is made of synthetic resin.

Preferably, in addition to the above, by using thermally-resistant synthetic resin such as polyphenylene oxide system, aromatic polyamide system, ethylene fluoride system, or polyimide system as a rack possibly to be high-temperature heated induced by placement and fixation onto the roof, ensuring thermally-resistance to the rack restrains ill effect of the rack to the by high-temperature heat as much as possible, secures roofing the solar cell module for long period, and also restrains problems accompanied by roofing using synthetic resin made rack as much as possible. This is made such that synthetic resin includes thermally-resistant synthetic resin.

Preferably, in addition to the above, by using deformable polyphenylene ether resin of miscible polymer alloy, such as polyphenylene ether and polystyrene, polyamide, polyolefin or polyphenylene sulfide, high thermal resistance to the rack is secured, and ill effect to the rack is eliminated induced by the high-temperature heat as much as possible. Coefficient of linear expansion and specific gravity thereof as small as possible avoids ill effect of thermal expansion shrinkage of the rack on the roof lightens the solar cell module as much as possible. This is made such that thermally-resistant synthetic resin includes deformable polyphenylene ether resin.

Preferably, in addition to the above, forming the rack with a terminal box by the rack body and the rack cover facilitates arrangement of such a terminal of the terminal box and cables between between-terminals lead or the terminal and the connector and secures assembling workability of the solar cell module. This is made such that the rack in which the terminal box is arranged includes a rack body having the terminal box, and a rack cover having a holding groove formed therein, the holding groove receiving and holding between the rack body and the solar cell module a top of the solar cell module.

The invention related to a roofing structure of a solar cell array, wherein using the solar cell module with the rack above descried along with a starter, the solar cell modules are serially roofed based on the starter, completing roofing on the spot work as readily as possible, providing the roofing structure of the solar cell array securing well fitting of the upper and lower solar cell modules. This is made such as to include the solar cell module described above, wherein a starter is arranged near roof eaves, a lower side of the bottom solar cell module is located and fixed, the solar cell module is arranged onto the roof by the plurality of racks arranged in the top end length direction, the above solar cell module is placed and fixed to the racks, and is arranged on the roof by the plurality of racks arranged in the top end length direction, the top solar cell module is arranged on the roof by the racks, the connection cable of each of the solar cell modules adjacent to one another is mutually connected, and is connected to a power conditioner, and the solar cell array is consequently roofed on the roof face.

The invention is, as subject matter, designed to resolve the above problems.

### [Advantageous Effects of Invention]

According to the foregoing structures, since the plurality of racks are placed at the top end of the solar cell module in the length direction; and placed and fixed onto the roof so as to roof the solar cell module onto the roof via the racks; the terminal box is provided integrally or in the integrated fashion to the portion or entirety of the rack in the top end length direction; the connector is provided to the terminal box, and the connecting cable along the top end; and thus components required for roofing the solar cell module are integrated as much as possible, it is made possible to complete roofing the solar cell module by placing and fixing the foregoing rack onto the roof, on the spot as much as possible, and to ultimately simplify working on the spot.

The invention according to the foregoing structure, in addition to the above, since fixing the rack onto the roof is made such as to directly place and fix the rack onto the roof face of the roof with the fixture such as screw or nail, it is made possible to roof the solar cell module with general tool such as electric screwdriver or hammer.

The invention according to the foregoing structure, in addition to the above, since the lower side of the upper solar cell module located vertically is fixed to the rack fixed to the lower solar cell module with fixture; and the upper solar module is securely roofed subsequently toward vertical direction without being blown out, it is made possible to fix well and secure the solar cell module to the roof face.

The invention according to the foregoing structure, in addition to the above, since the rack of such material is made as light as possible in order to restrict a weight increase of the solar cell module induced by arrangement thereof, it is made possible to highly secure processing accuracy as much as possible as the rack to roof the solar cell module.

The invention according to the foregoing structure, in addition to the above, since for the rack possibly to be high-temperature heated induced by placement and fixation onto the roof, thermally-resistant synthetic resin is used, it is made possible to restrain as much as possible ill effect of the rack to high-temperature heat through ensuring thermally-resistance to the rack; to secure roofing the solar cell module for a long period; and also to restrain as much as possible problems accompanied by roofing using synthetic-resin-made rack.

The invention according to the foregoing structure, in addition to the above, since deformable polyphenylene ether resin is used, it is made possible to highly secure thermal resistance to the rack; to eliminate as much as possible ill effect to the rack induced by the high-temperature heat; and to avoid ill effect of thermal expansion shrinkage of the rack on the roof and to lighten the solar cell module as much as possible by coefficient of linear expansion and specific gravity thereof made as small as possible.

The invention according to the foregoing structure, in addition to the above, since the rack with a terminal box is formed by the rack body and the rack cover, it is made possible to facilitate such arrangement of the terminal of the terminal box and cables between from lead between terminals to the terminal and the connector, and secure assembling workability of the solar cell module.

The invention according to the foregoing structure, since the solar cell module with the rack descried above along with a starter are used, it is made possible to serially roof the solar cell modules based on the starter; to complete roofing on the spot by work as ready as possible; and to provide the roofing structure of the solar cell array securing good fitting of the upper and lower solar cell modules.

### [Brief Description of Drawings]

[Fig. 1]

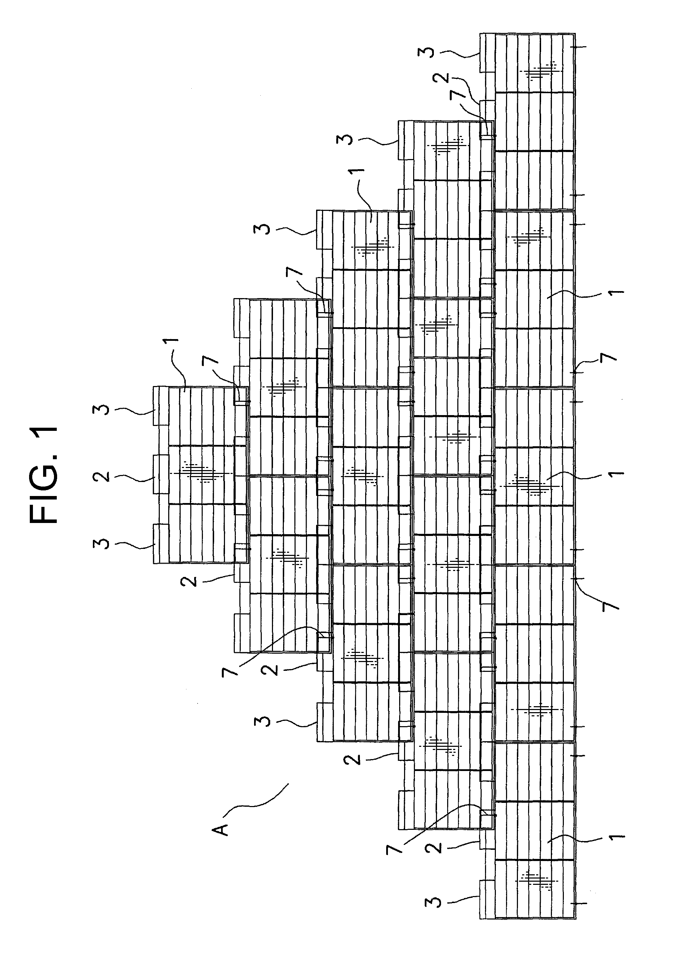

   FIG. 1 is a front view illustrating an arrangement state of a solar cell array;
[Fig. 2]

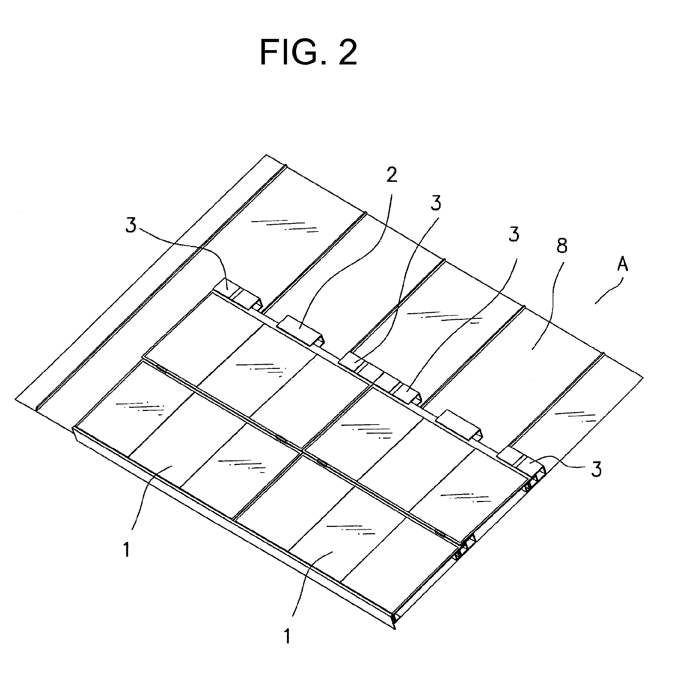

   FIG. 2 is a partial perspective view illustrating a placement state of a solar cell module;
[Fig. 3]

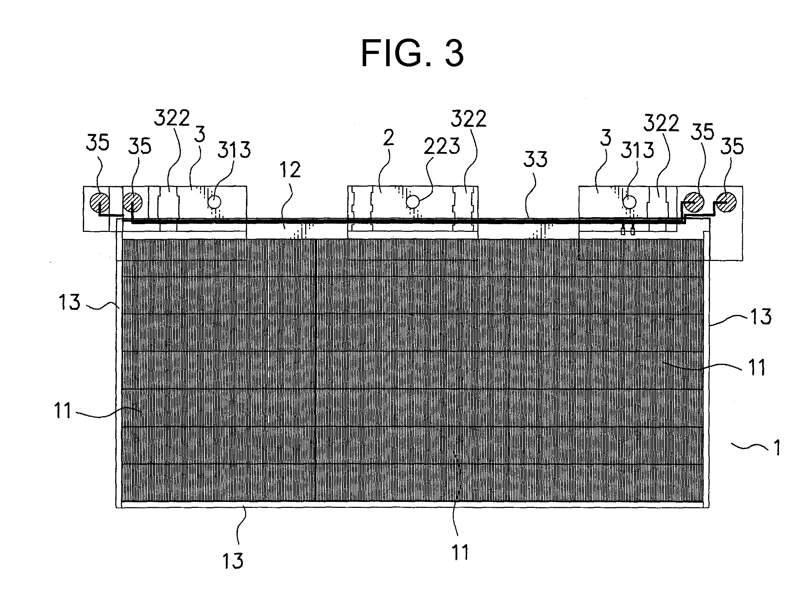

   FIG. 3 is a front view of the solar cell module;
[Fig. 4]

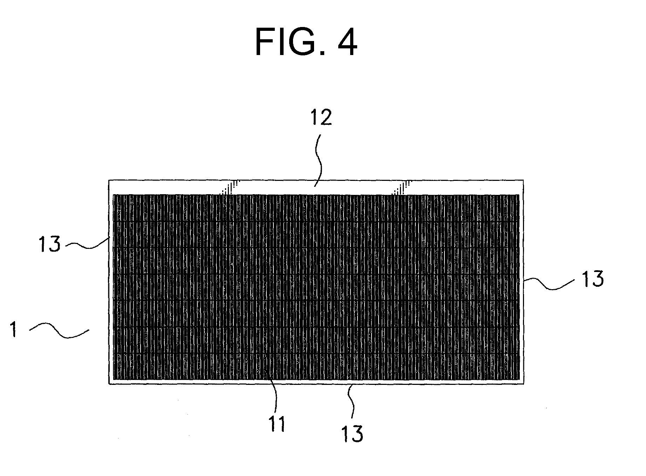

   FIG. 4 is a front view of a solar cell module body;
[Fig. 5]

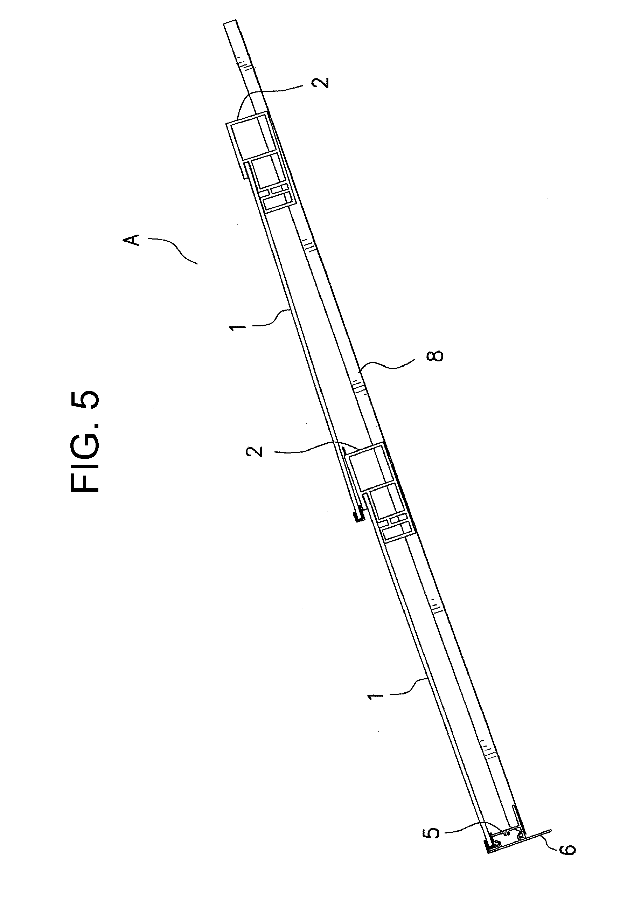

   FIG. 5 is a cross-sectional view of a roof illustrating relationship between the solar cell module and a rack;
[Fig. 6]

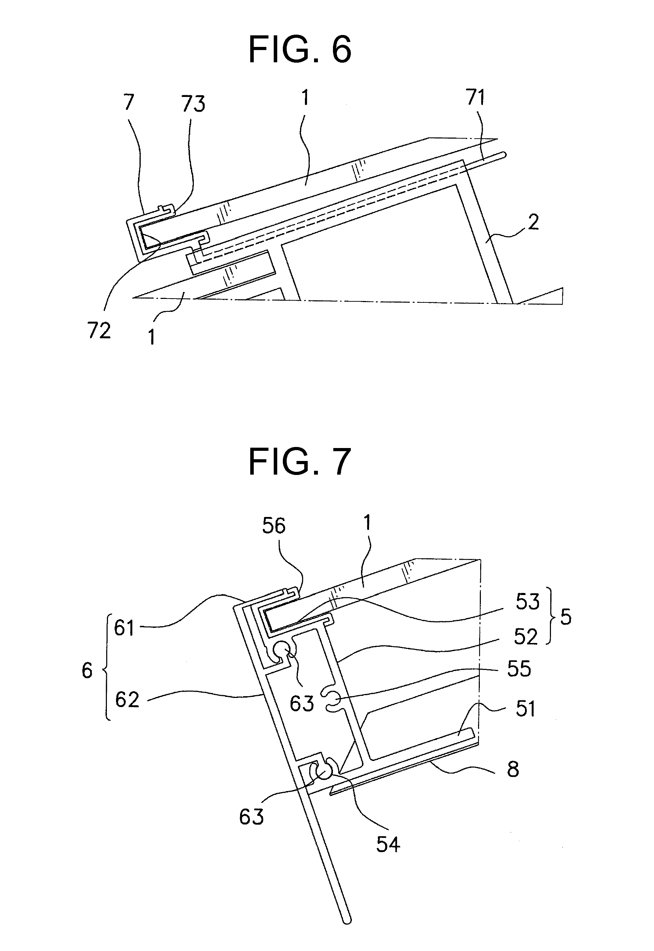

   FIG. 6 is a partial cross-sectional view illustrating a fixing state of a lower side of the solar cell module;
[Fig. 7]
   FIG. 7 is a partial cross-sectional view illustrating a fixing state of the solar cell module near roof eaves;
[Fig. 8]

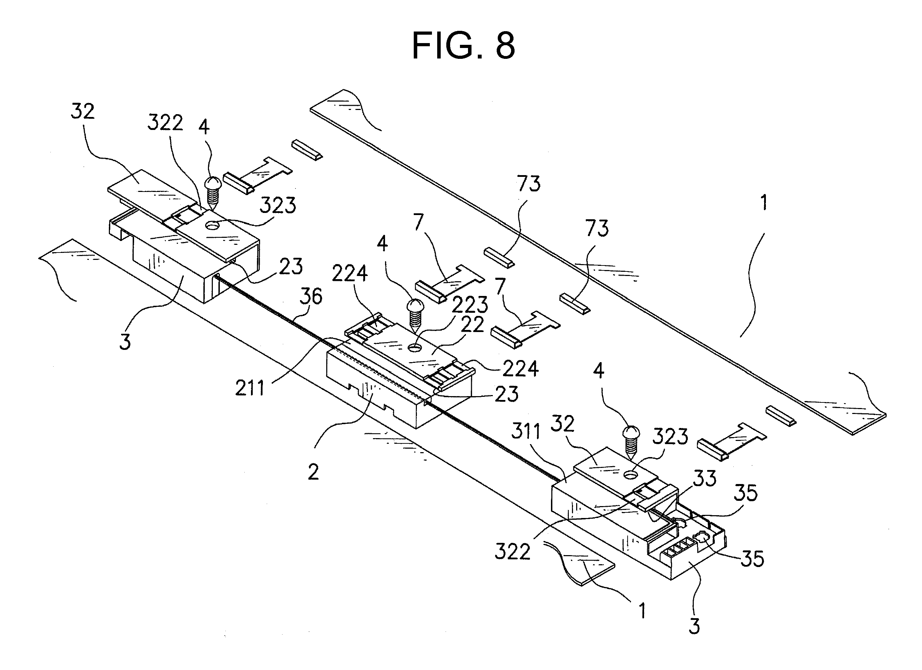

   FIG. 8 is a perspective view illustrating a relationship between the rack and the solar cell module;
[Fig. 9]

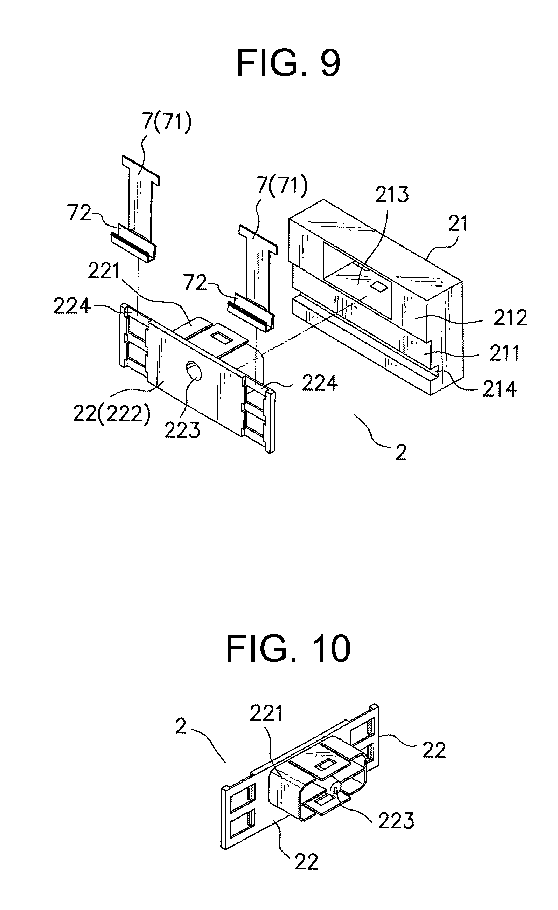

   FIG. 9 is an exploded perspective view of the rack located in a middle;
[Fig. 10]
   FIG. 10 is a bottom view of a rack cover located in a middle;
[Fig. 11]

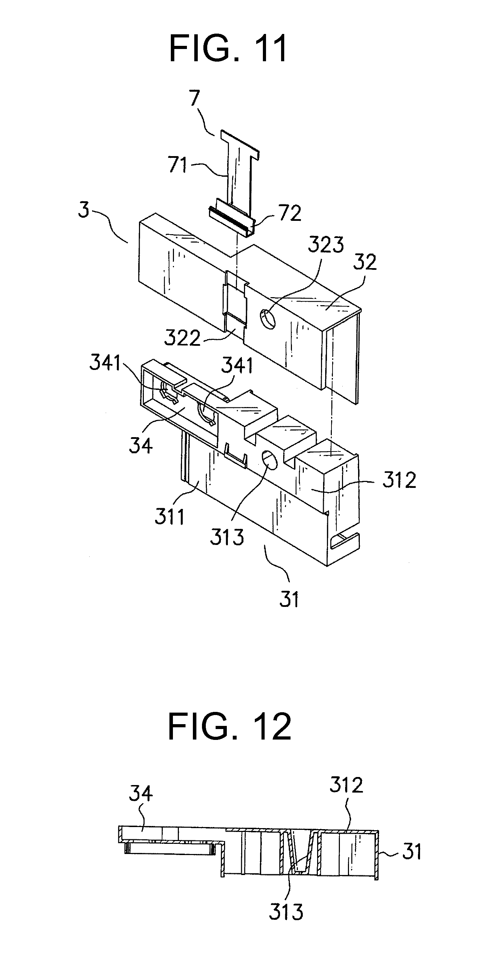

   FIG. 11 is an exploded perspective view of the rack located leftward;
[Fig. 12]
   FIG. 12 is a vertical cross-sectional view of the rack located leftward;
[Fig. 13]

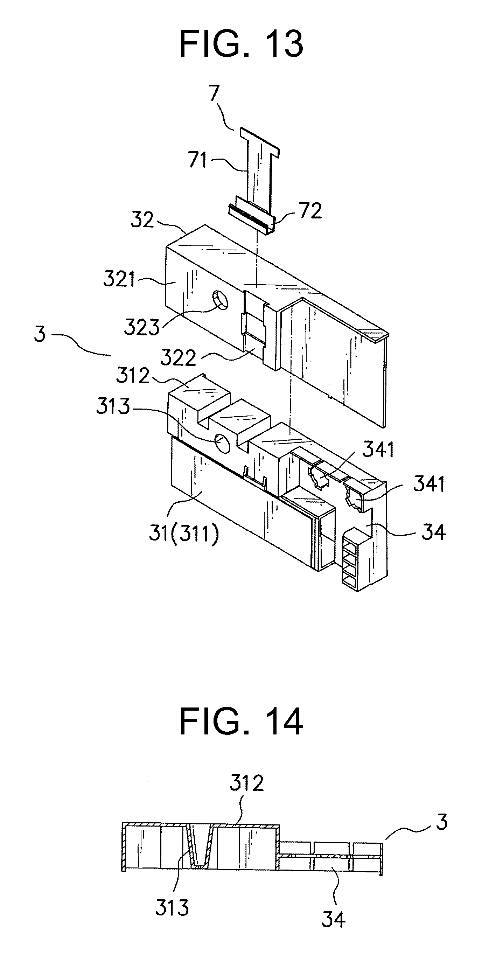

   FIG. 13 is an exploded perspective view of the rack located rightward;
[Fig. 14]
   FIG. 14 is a vertical cross-sectional view of the rack located rightward;
[Fig. 15]

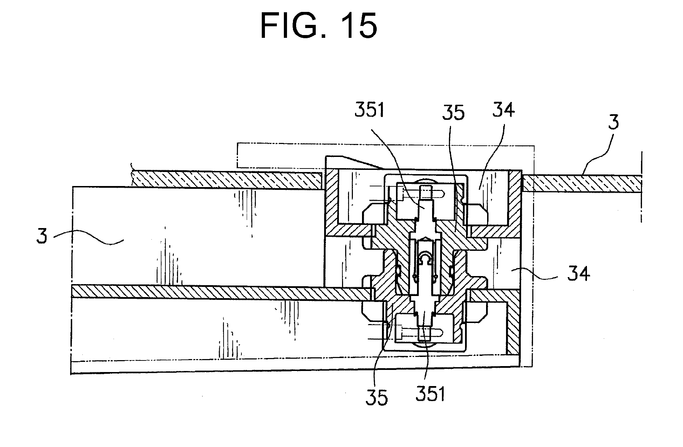

   FIG. 15 is a vertical cross-sectional view illustrating a connection relationship of a connector.

### [Description of Embodiment]

According to an example of the following drawings the present invention will be specifically described. The reference sign A shows a solar cell array formed by roofing zigzag on a slanted roof face of a roof 8 such as, for example, gabble or hipped roof formed such that roof material, or Galvalume steel sheet in the invention, is vertically roofed, and the reference sign 1 a solar cell module composing a solar cell array A. The solar cell module 1 can be roofed on the roof face via the racks by a plurality of racks 2, 3 being placed in a top end length direction, and being placed and fixed to the roof. Furthermore, a terminal box 34 is placed in the top end length direction integrally or in a integrated manner to a part or entirety of the racks, and connection of a connector 35 arranged to the terminal box 34 allows a connecting cable 36 to be placed in the top end length direction. At this time, the racks 2, 3 of the invention are placed and fixed to the roof 8 with fixture such screw or nail, or in the present embodiment a fixture of a screw 4 directly attached to the roof face.

The solar cell module 1 of the present example is formed according to such a conventional manner that between a front cover and a back cover a solar cell 11, an interconnector, and filler are filled. At this time, the solar cell module 1, especially a body thereof, is placed such that a surface area of the back cover and/or that of front cover is made enlarged more than a placement area of the solar cell 11, along which placed on a top thereof is a wide upper side, for example, of several centimeters, or a wide rib 12 in the order of 5 cm in the present embodiment, at side end and bottom end of which placed is a narrow and lower side ribs or, for example, a narrow rib 13 in the order of 1 cm. In the solar cell module of the embodiment, the racks 2, 3 are placed to the wide ribs 12 of the body in the top end length direction, namely, both right and left ends and a middle in a wide length direction, in the present embodiment in three center places, so as to fix directly with fixture to the roof face 8. At this time, a fixture receiver 224, 322 for fixture 7 fixing a lower side of the above-arranged solar cell module 1 on the roof face, i.e., the narrow rib 13 are placed to a portion or an entirety of the rack 2, 3, or in the embodiment the entirety, especially, two places at both ends of the centrically located rack 2 and one place of each of the rightward and leftward located racks 2.

Of three places at the top end, i.e., the upper side of the wide rib 12, the foregoing two rightward and leftward, especially at both ends, located rack 3 at two places is provided with the foregoing terminal box 34, so as to serve as both fixture of the solar cell module 1 to the roof 8 and output of its power, but the centrically located rack 2, which is in the embodiment centrically located at one place, without the foregoing terminal box, serves as fixture for fixing the solar cell module 1.

The foregoing racks 2, 3, regardless with or without the terminal box, is made of hard synthetic resin so as to secure its processing accuracy and reduce its weight as much as possible to restrict its weight increase. For the hard synthetic resin a various types such as acrylonitrile-butadiene-styrene resin can be used, but in the embodiment thermally-resistant synthetic resin is used as material to place and fix the solar cell module 1, so as to obtain thermally resistance against high-temperature heating to which the roof 8 is subject, achieving securing the solar cell module 1 to be for a long time placed and fixed.

The thermally-resistant synthetic resin of the racks 2, 3 may be optionally selected from polyphenylene oxide system, aromatic polyamide system, ethylene fluoride system, or polyimide system, and be formed integrally with injection molding or extrusion molding of the thermally-resistant synthetic resin, or be formed such that multiple integrally-formed members are integrated by engagement, welding, or fixture.

The thermally-resistant synthetic resin may include deformable polyphenylene ether resin, and, e.g., Xyron (trademark) made by Asahi Kasei. Co., is used and molded, so as to exhibit thermally-resistance of 170° C, specific weight of 1.06 to 1.10, low linear expansion coefficient of 5 X 10⁻⁵ mm/mm/° C, acid-resistant and alkali-resistant property, contributing thermally-resistance to high-temperature heating on the roof and weight reduction of the solar cell module.

The racks 2, 3 of the embodiment have the rack bodies 21, 31 and rack covers 22, 32 formed integrally, for example, by injection molding, to be formed into a rectangular block-like shape using multiple members, or in the present embodiment two members. The two members are used to be integrated upon roofing the solar cell module 1 to the roof 8 as mentioned below.

The racks 2, 3 of the present embodiment have, e.g., a width of 12 cm, a length of 20 cm to 25 cm, and a height of 5 cm, and have its bottom face slanted in compliance with the roof 8, so as to be slanted in the same manner as is slanted with respective to the roof face upon placement to the roof 8. The centrically located rack 2 is provided with a holding groove 23 receiving and holding between a top face of the rack body 21 and the rack cover 22 the upper side so as to place and fix the solar cell module 1 at the upper side, namely, a middle in a length direction of the wide rib 12, or in the present embodiment centrically. The right and left positioned racks 3, in the present embodiment at right and left ends positioned in two places, are each provided with terminal boxe 34, and is provided with a holding groove 33 at the foregoing upper side between an upper face of the rack body 31 and the rack cover 32 so as to place and fix at an upper side of the solar cell module 1, in the present embodiment an end in a length direction of the foregoing wide rib 12. Threading of a fixture, in the present invention a screw 4, from a top face of the rack cover 32 into the roof face allows the solar cell module 1 inserted and fixed into the holding groove 33 by the rack body 31 and the rack cover 32, to be integrally fixed by direct fixture to the roof face of the roof 8 of which the foregoing roof material is made of Galvalume steel sheet. The upper side of the solar cell module 1, i.e., three places in the length direction of the wide rib are held by these racks 2, 3 at predetermined intervals, and is roofed to the roof 8. Also, arrangement integral or in a integrated manner with the foregoing terminal box 34 to the rack 3 allows the connector 35 arranged in the terminal box 34 to be mutually connected to complete electrical connection between the roofed solar cell modules 1.

In the rack 2, i.e., the centrically located rack, is made as shown in FIGS 9 and 10 such that the rack body 21 is rectangular block-like shaped in which a strike plate 211 placing thereon and holding from below the upper side of the solar cell module and a cover placement face 212 located above the strike plate by a step corresponding to a thickness of the solar cell module 1 are provided; a landscape-rectangular receiving hole 213 is placed centrically in a width direction of the cover placement face 212, in the present embodiment centrically; and a cable through hole 214 is placed passing therethrough the rack body 21 entirely in a width direction in front of the foregoing strike plate 211. The rack cover 22 also includes a rectangular engaging leg 221 engaging with the receiving hole 213, and is front side T-shaped arranging a cover plate 222 at both ends thereof covering the cover placement face 212 and being widened in its back and forth such as to project from the cover placement face 212 toward the strike plate 211 by about 2 to 3 cm. A cross-sectional V-shaped thread insertion guide 223 opening toward a top face of the engaging leg 221, guiding the screw 4 threading into the roof face, is integrally placed inside the engagement leg 221. Furthermore, the rack cover 22 is provided with a fixture receiver 224 fixing the lower side of the above-located solar cell module 1, i.e., the narrow rib 13, by the fixture 7 to be mentioned below, or in the present embodiment a receiving groove receiving and holding fixing the fixture 7,for example, a latch groove with a latch projection at an opposed one end, toward back and forth along the roof-slanted direction at both ends of the foregoing thread insertion guide 223 or in the present embodiment in a pair in its width direction.

The rack, or the right and left positioned rack 3 with the terminal box is, as shown in FIGS. 11 and 12 as what is located left, made in such a fashion that the leftward rack body 31 of the rack 3 is provided with a strike plate 311 placing thereon the top end of the solar cell module 1 and holding it from below, and a cover placement face 312 positioned above the strike plate 311 by a step of the thickness of the solar cell module 1; the terminal box 34 with about half height, top face of which opens toward one end of the cover placement face 312 in its width direction, i.e., leftward, thickness of which is made, for example, approximately half that of the rack body 31 to become flush with the cover placement face 312, exposing and reducing its thickness by , is integrally placed partially projecting; and a cross-sectional V-shaped thread insertion guide 313 is integrally placed centrically in a width direction of the cover placement face 312, which guides the screw 4 threading into the roof face. The rack cover 32 is made such that a cover face is cross-sectionally U-shaped covering a cover face 321 of an upper face and a cover face, the cover face 321 covering successively the cover placement face 312 of the rack body 31 and a top face of the terminal box 34, and being formed wide in back and forth so as to project from the cover placement face 312 toward the strike plate 311 by about 2 to 3 cm, the cover face covering a back face and a bottom face of the rack body 31; a fixture receiver 322 fixing the fixture 7 of the narrow rib 13, in the present embodiment a similar receiving groove, in the present embodiment a latch groove with latch, is placed at a middle in its width direction of the cover face 321 of the top face, in the present embodiment centrically and singly; and a screw insertion hole 323 having the screw 4 inserted is placed at one side thereof, in the present embodiment leftward, at a position corresponding to the foregoing thread insertion guide 313 of the rack body 31.

On the other hand, as shown in FIGS. 13 and 14 as what is located rightward, the rightward rack body 31 of the rack 3 is made such that a strike plate 311 and a cover placement face 312 are placed, the strike plate having the upper side of the solar cell module 1 placed thereon and holding it from below, the cover placement face 312 being positioned above from the strike plate 311 via a step by the thickness of the solar cell module 1; a terminal box 34 with about half height is integrally placed such that a lower step is made rightward with respect to the cover placement face 312 partially projecting, the top face of which opens toward one side in a width direction of the cover placement face 312, i.e., rightward, thickness of which is made, for example, about half that of the rack body 31, and top face of which is positioned below by its thickness; and a cross-sectionally V-shaped thread insertion guide 313 is placed at a middle in a width direction of the cover placement face 312, the thread insertion guide 313 guiding the screw threading into the roof face. The rack cover 32 is made such that a cover face 321 of an upper face and a cover face of a back face are placed in cross-sectionally U-shaped, the cover face 321 covering the cover placement face 312 of the rack body 31, being formed wide in back and forth so as to project from the cover placement face 312 toward the strike plate 311 by about 2 to 3 cm, and having a length thereof in compliance with the cover placement face 312 excepting the terminal box 34, the cover face covering wholly a back face and a bottom face; a fixture receiver 322 fixing the fixture 7 of the narrow rib 13, in the present embodiment a similar receiving groove, in the present embodiment a latch groove with latch is placed at a middle in a width direction of the cover face 321 of the top face, in the present embodiment centrically and singly; and a screw insertion hole 323 having the screw 4 inserted into the thread insertion hole 313 is placed at one side thereof, in the present embodiment leftward, at a position corresponding to the foregoing thread insertion guide 313 of the rack body 31.

The centrically positioned rack 2 and the right and left positioned racks 3, which are respectively composed of the rack bodies 21, 31, and the rack covers 22, 32, are placed onto the upper side of the solar cell module 1, i.e., the wide rib 12 is placed onto the strike plates 211, 311 of the rack bodies 21, 31. The cover placement face 212 of the rack bodies 21, 31, the back face and the bottom face are covered by the rack cover 22, from the top face of which, i.e., the thread insertion guide 223 of the rack covers 21, 31 or the screw through hole 323 of the rack cover 32, the screw 4 is threaded into the roof face from the top faces, so as to respectively combine the rack covers 22, 32 with the rack bodies 21, 31, and holding grooves 23, 33 of 2 to 3 cm in thickness according to the foregoing projecting width, receiving and holding the wide rib 12 of the solar cell module 1 is formed between the strike plates 211, 311 of the rack bodies 21, 31 and the rack covers 22, 32, and receives and holds by the holding grooves 23, 33 the upper side of the solar cell module 1 at three places centric and right and left in its width direction, which forms the racks 2, 3, in the present embodiment by the rack bodies 21, 31 and the rack covers 22, 23, and directly roofs the solar cell module 1 to the roof face by the fixture of the screw 4 of the racks 2, 3, making stable and secure roofing.

At this time, the racks 3 positioned right and left are each placed in such a fashion that the left positioned has its terminal box 34 project leftward beyond a left end of the solar cell module 1, the right positioned has its terminal box 34 project rightward beyond a right end of the solar cell module 1. Upon roofing the solar cell modules 1 neighboring right and left, the terminal box 34 in the left positioned rack 3 of the neighboring solar cell module 1 is overlaid vertically onto the terminal box 34 positioned below in the right positioned rack 3, pressing the left positioned rack 3 from above couples the connector 35 vertically divided in half with the terminal box 34 positioned right and left, and connection of the terminal 351 held thereby electrically mutually connects the terminal boxes 34 of the racks 3.

The foregoing left positioned rack 3 is made such that the terminal 351 arranged in the terminal box 34 is connected to an output terminal of the solar cell module 1, and the connection cable 36 from the terminal box 34 is connected to the terminal 351 arranged in the terminal box 34 of the right positioned rack 3 so as to transmit power outputted from the solar cell module 1. The connection cable 36 is arranged to be placed from the left positioned rack 3 via the foregoing middle positioned rack 2 through the cable though hole 21 along the top end length direction of the solar cell module 1 to the upper in a length direction of the wide rib 12 of the upper side in the present embodiment.

Roofing the solar cell module 1 using the racks 2, 3 positioned in three places of middle, right and left is made such that the starter 5 is located near the roof eaves; the lower side of the lowermost solar cell module 1 is positioned and fixed; the plurality of racks 2, 3 arranged in the top end length direction has the solar cell module 1 placed onto the roof; onto the racks 2,3 the upper solar cell module 1 is placed and fixed; the plurality of racks 2, 3 arranged in the top end length direction has the upper solar cell module 1 placed onto the roof 8, and ultimately has the uppermost solar cell module 1 placed onto the roof 8; and mutual connection of the connection cable 36 with the solar cell modules neighboring right and left and connection to the power conditioner completes roofing onto the roof face.

Namely, as roofing the solar cell module 1 is made such that using the starter 5 the solar cell module 1 is arranged in the foregoing zigzag manner, in the neighboring right or left solar cell module 1 that is first roofed, the terminal boxes 34 of the rack 3 between the neighboring solar cell modules 1 are mutually overlaid so as to perform coupling the foregoing connectors 35 and connecting the terminal 351, in the vertically neighboring solar cell module 1 that is latterly roofed, since the bottom end thereof, especially the bottom line thereof, is naturally determined, direct fixture to the roof face may be performed by placement and fixture relative to the tracks 2, 3 of the top end. It follows from this that the first roofed solar cell module 1 achieves positioning the latterly roofed solar cell module 1, avoiding working for discrete alignment of the solar cell module 1, forming the solar cell array A by ready roofing work of placing and fixing serially upwardly the solar cell module 1.

In the present embodiment, the starter 5 used for roofing the roof eaves side (i.e., lowermost) solar cell module 1 of the solar cell array A, and for positioning the lowermost solar cell module 1, is provided with a fixture piece 51 placed and fixed to the roof face, a stand piece 52 upstanding from the roof eaves end of the fixture piece 51 in accordance with a height of the racks 2, 3, a receiving groove 53 opening toward ridge side, arranged at a top end of the stand piece 52, and receiving a bottom line of the solar cell module 1. In the present embodiment, a bearing-like bearing strips 54 near the roof eaves of the foregoing fixture piece 51 and a lower end of the receiving groove 53, and a tapping hole 55 at a vertical middle of the stand piece 51 are further arranged which are, for example, made of extrusion molding material of aluminum or hard resin, and the lower side of the solar cell module 1 is directly or indirectly via cushioning material is received, in the present embodiment, for example, indirectly via piece-like cushioning material by cross-sectionally U-shaped grazing channel 56, and consequently the lowermost solar cell module 1 is positioned. The starter 5 is at this time provided with a roof eaves cover 6 making up and covering the starter 5 near roof eaves; the roof eaves cover 6 is provided with a latch strip 61 covering, in such a manner of latching, a top face of the receiving groove 53, a front cover strip 62 projecting downward from a cover-like end near roof eaves and covering a front near roof eaves toward roof lower position from the starter 5. Furthermore, in the present embodiment engaging strips 63 are each placed such as to be formed into a cross-sectional L shape at a vertical middle on a roof ridge side face of the front cover strip 62. It follows from this that the engaging strip 63 of the roof eaves cover 6 is, for example, slidably engaged from an end in a length direction with the fixing piece 51 of the starter 5 and the receiving strip 54 of a lower end of the receiving groove 53, and the roof eaves cover 6 is integrated with the starter 5, making up and covering a roof eaves side. At both ends thereof not-shown side covers are at this time arranged, and is screwed to the tapping hole 55 of the starter 5 so as to close an end in a length direction.

On the other hand, the solar cell module 1 located above the lowermost solar cell module 1 roofed positioned by the starter 5 is placed and fixed to the racks 2. 3 fixing the upper side of the lowermost solar cell module 1, in the present embodiment the foregoing wide rib 12; the foregoing upper side is at the same time similarly fixed to the roof face with the nail 4 by the racks 2, 3 for the foregoing upper solar cell module; by serially repeating this manner, the solar cell array A arranged zigzag is configured with predetermined steps. At this time, fixing of the lower side of the upper solar cell module 1 in the present embodiment, in the present embodiment the narrow rib 13, is made such that using the fixture 7, the fixture 7 is received and held in fixture receiver 224, 322 disposed in each of the rack covers 22, 32 of the racks 2, 3, i.e., the latch groove having the latch projection at one side of the opposite end, and the lower side of the solar cell module 1 is similarly received and held in the receiving groove 72 opening toward the ridge of the roof, and fixed to the racks 2, 3 via the fixture 7. In the present embodiment, the fixture 7 is provided with a fixing piece 71 placed and fixed to the roof face; and a receiving groove 72 opening toward the roof eaves receiving the lower side of the solar cell module 1 arranged such as to latch the side and the end near the roof eaves of the latch groove of the lack having its both ends in its length direction project, so as to form a T-shape together with the fixing piece 71 near roof eaves side of the fixing piece, which the fixture 7 is similarly made of extrusion molding material of aluminum or hard synthetic resin. The fixture 7 has the fixing piece 71 inserted and latched in racks 2, 3 in the foregoing three places, and has the bottom line of the upper solar cell module 1 similarly, directly or indirectly via cushioning material received in the receiving groove 72 near the roof eaves, in the present embodiment, for example, indirectly via piece-like cushioning material by cross-sectionally U-shaped grazing channel 73, so as to position the bottom line of the upper solar cell module 73 and to similarly fix it with the screw 4 by the racks 2, 3 of the three places for the upper side. As such fixing and positioning the upper solar cell module 1 to the racks 2, 3 of the lower solar cell module 1 allows the upper solar cell module 1 to be naturally positioned to be roofed. Therefore, roofing of the solar cell module 1 using the racks 2, 3 can be made by fixing the racks 2, 3 with the screw 4; receiving and holding the lower line of the upper solar cell module 1 using the fixture 7 to the racks 2, 3; and electrically connecting by the connector 35 in the rack, especially the rack 3 at right and left ends.

In the present embodiment, since the right and left positioned rack 3 is electrically connected through coupling the connector 35 virtually divided in half by overlaying of the foregoing terminal boxes to each other and through connecting the terminal 351, overlaying right position and the left positioned rack 3 of each of the neighboring solar cell modules 1 in such a manner as to press downward the left positioned rack 3, may make electrical connection in series to transmit generated power to the foregoing power conditioner every solar cell module 1 of each step arranged zigzag. Thereby, without discrete connection of the terminal box 34 disposed in the solar cell module 1, connection work of the terminal box 34 along with fixture of the solar cell module 1 to the roof face can be performed, further facilitating roofing work.

While the solar cell array A configured as such, has arrangement of the solar cell module 1 formed zigzag as generally configured, roofing the solar cell module 1 is made based on the starter near the roof eaves, fixed by fixture of the screw 4 to the roof face using the foregoing racks 2, 3, which makes possible utmost simplification and assurance without positioning work for which was conventionally required, and disposition of the terminal box 34 by the rack, especially right and left positioned rack 3, allows for simultaneous and conclusive electrical connection required for the solar cell array A, facilitating roofing work in the site of the solar cell array A significantly, highly securing workability. Since the upper solar cell module 1 has its lower side secured by the fixture 7 to the racks 2, 3 fixing the lower solar cell module 1, roofing on the roof face secures high wind pressure resistance even against strong wind such as typhoon including blowing up, keeping roofing state for a long period.

Reference sign 341 in the figures illustrates a connector hole used for arranging the connector 35 through the terminal box 34.

While illustrated embodiments are described above, various configurations, but within the subject matter of the invention, upon the present invention being reduced to practice, can be adapted such as each specific form, structure, material, number, size, relation thereof, addition to these, method of roofing of rack, terminal box, connector, connection cable, if necessary, rack body, rack cover, starter, fixture, fixing receiver, or the like as follows: such as rack, especially rack for placement and fixture is placed in the plural and the number of racks of the upper end of the solar cell module is made plural; each rack is formed integral with an insertion hole of the upper side of the solar cell module instead of or along with the rack cover; the rack is formed as a common member such as to be commonly used for what is in a middle and for what is positioned right and left provided with the terminal box; the insertion hole is integrally formed by some molding to the rack, the rack body or the rack cover by the foregoing rack cover including the above instead of configuration of forming the holding groove of the solar cell module; members are commonly used as much as possible of the racks positioned centrically, right and left; also including this case, for example, the terminal box is separately formed so as to latterly incorporate back and forth, and right and left the rack and the rack body to dispose integrally; as the fixture used for fixing the rack is set a screw, for example, to undergo retaining measure as by adhesive; as the fixture of nail is set a screw nail, to undergo similar to the screw retaining measure as by adhesive; and the fixture fixing the starter and/or the bottom line of the upper solar cell module is set, for example, a cross-sectionally S-shaped hook, the bottom line of the solar cell module is inserted into the upper hook, a projection of the lower hook is latched into the receiving groove formed back the rack.

### [Reference Signs List]

A solar cell array
1 solar cell module
11 solar cell
12 wide rib
13 narrow rib
2 centrically positioned rack
21 rack body
211 strike plate
212 cover placement face
213 receiving hole
214 cable through hole
22 rack cover
221 engaging leg
222 covering plate
223 thread guide
224 fixture receiver
23 holding groove
3 right an left positioned rack
31 rack body
311 strike plate
312 cover placement face
313 thread guide
32 rack cover
321 upper covering face
322 fixture receiver
323 screw through hole
33 holding groove
34 terminal box
341 connector hole
35 connector
351 terminal
36 connection cable
4 screw
5 starter
51 fixing piece
52 stand piece
53 receiving groove
54 receiving strip
55 tapping hole
56 grazing channel
6 roof eaves cover
61 latch strip
62 front covering strip
63 engaging strip
7 fixture
71 fixing piece
72 receiving groove
73 grazing channel
8 roof

## Claims

1. A solar cell module comprising:
a plurality of racks located in a top end length direction of the solar cell module;
a terminal box integrally or in an integrated fashion located across some of or all of the racks arranged in the top end length direction;
a connector located in the terminal box; and
a connecting cable configured to be arranged along the top end length direction,
wherein placing and fixing the racks to a roof allows the solar cell module to be roofed onto the roof via the racks, and wherein connecting of the connector arranged in the terminal box allows the connecting cable to be arranged in the top end length direction.

2. The solar cell module as claimed in claim 1, wherein the rack is placed and fixed to the roof by directly fixing the rack to a roof face of the roof by a fixture such as a screw or a nail.

3. The solar cell module as claimed in claim 1, further comprising a fixture receiver for the fixture fixing a lower side of the above-located solar cell module, the fixture receiver being located across some of or all of the racks.

4. The solar cell module as claimed in any one of claims 1 to 3, wherein the rack is made of synthetic resin.

5. The solar cell module as claimed in claims 4, wherein synthetic resin includes thermally-resistant synthetic resin.

6. The solar cell module as claimed in claims 5, wherein thermally-resistant synthetic resin includes deformable polyphenylene ether resin.

7. The solar cell module as claimed in any one of claims 1 to 6, wherein the rack in which the terminal box is disposed includes a rack body having the terminal box, and a rack cover having a holding groove receiving and holding a top end of the solar cell module between the rack body and the rack cover.

8. A roofing structure of a solar cell array comprising:
the solar cell module as claimed in any one of claims 1 to 7, wherein a starter is arranged near roof eaves so as to position and fix a lower side of the lowermost solar cell module, and the solar cell module is arranged to the roof by the plurality of racks arranged in the top end length direction,
wherein the above-arranged solar cell module is placed and fixed to the racks, the above-arranged solar cell module is arranged on the roof by the plurality of racks arranged in the top end length direction,
wherein the uppermost solar cell module is likewise arranged on the roof by the racks, and
wherein the connection cables of the right and left neighboring solar cell modules are mutually connected, and are connected to a power conditioner, and thereby roofing the solar cell array on the roof face.
